# NEUE EUROPÄISCHE PATENTSCHRIFT

(11) **EP 0 172 393 B2**
(45) Veröffentlichungstag und Bekanntmachung des Hinweises auf die Entscheidung über den Einspruch: **28.02.1996**
(45) Hinweis auf die Patenterteilung: 17.10.1990
(21) Anmeldenummer: 85108738.7
(22) Anmeldetag: 12.07.1985
(51) Int. Cl.: H03K 17/95, H03B 5/12

(54) **Oszillator/Demodulator-Schaltungsanordnung für einen induktiven Annäherungsschalter**
Oscillator/demodulator circuit arrangement for an inductive proximity switch
Circuit oscillateur-démodulateur pour un commutateur de proximité inductif

(30) Priorität: 13.07.1984 DE 3425937
(43) Veröffentlichungstag der Anmeldung: 26.02.1986
(73) Patentinhaber: SIEMENS AKTIENGESELLSCHAFT, D-80333 München (DE)
(72) Erfinder: Gehring, Gerhard, Dipl.-Ing., D-8025 Unterhaching (DE); Hödlmayr, Franz, Dipl.-Ing., D-8000 München 90 (DE)

(56) Entgegenhaltungen:
- GB-A- 2 075 201
- ELECTRONIQUE ET MICROELECTRONIQUE INDUSTRIELLE, 15. Juni 1975, Seiten 54-56, Paris, FR; J.-M. ZULAUF: "Réalisez votre détecteur de proximité à seuils réglables"
- L'ELECTRICITE ELECTRONIQUE MODERNE, Band 44, Nr. 280, April/Mai 1974, Seiten 66-68, Paris, FR; C. BOISARD: "Un circuit intégré capteur de proximité pour l'automobile"

## Beschreibung

Die vorliegende Erfindung betrifft eine Oszillator/Demodulator-Schaltungsanordnung nach dem Oberbegriff des Patentanspruchs 1.

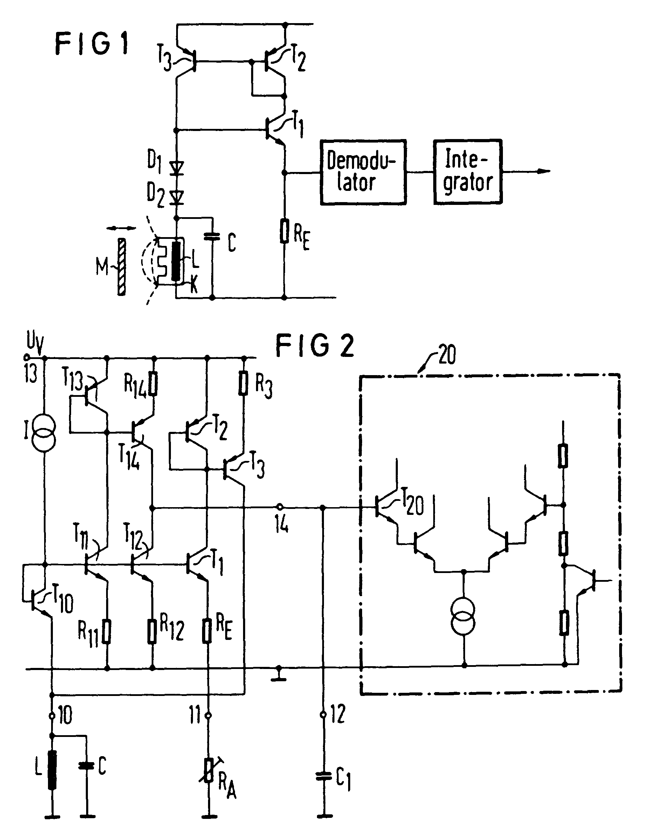

Eine derartige Schaltungsanordnung ist beispielsweise aus der Zeitschrift "Electronique et Microélectronique Industrielle", 15.06.1975, Seiten 54 bis 56 bekannt. Das Prinzip einer derartigen vorbekannten Schaltungsanordnung ist in Fig. 1 dargestellt. Diese Schaltungsanordnung enthält eine durch einen Transistor T₁ mit einem Emitterwiderstand R_{E} gebildete Transistorverstärkerstufe sowie eine Mitkopplung, die durch einen durch Transistoren T₂ und T₃ gebildeten Stromspiegel realisiert ist. Im Basiskreis des Transistors T₁ der Verstärkerstufe liegt ein durch einen Kondensator C und eine Spule L gebildeter Parallelresonanzkreis sowie in Serie zu diesem Resonanzkreis die Reihenschaltung zweier Dioden D₁ und D₂. Die Spule des Resonanzkreises besitzt einen offenen Halbschalen-Ferritkern K, wobei ein sich dadurch ausbildendes elektromagnetisches Feld schematisch durch gestrichelte Linien angedeutet ist. Wird dem Kern K ein Metallblech bzw. eine Metallfahne M angenähert, so wird ein Teil des genannten Feldes durch dieses Metallblech bzw. diese Metallfahne absorbiert und der Schwingkreis entsprechend bedämpft. Damit wird die Schwingungsamplitude kleiner oder die Schwingung reißt vollständig ab, wenn die Schleifenverstärkung kleiner als 1 wird.

In einer Schaltungsanordnung für einen Annäherungsschalter ist dem vorstehend erläuterten Oszillator ein Demodulator und ein Integrator nachgeschaltet, die in Fig. 1 lediglich schematisch dargestellt sind und auf die hier nicht näher eingegangen zu werden braucht.

Im vorstehend erläuterten Oszillator dienen die Dioden D₁ und D₂ zur Erzeugung einer Referenzspannung. Eine der Dioden dient dabei zur Kompensation der Schwellspannung der Basis-Emitterstrecke des Transistors T₁ der Verstärkerstufe, während die andere Diode den Spannungsabfall am Emitterwiderstand R_{E} und damit den Emitterstrom bestimmt. Der Emitterstrom kann nur so weit ansteigen, bis der Spannungsabfall am Emitterwiderstand plus der Basis-Emitterspannung des Transistors T₁ gleich der an der Basis dieses Transistors liegenden Referenzspannung ist, da der Gleichspannungsabfall an der Wicklung der Spule L vernachschlässigbar ist. Die Schwingamplitude des Oszillators hat also als Spitzenwert die Referenzspannung von einer Diodenflußspannung.

Der Temperaturgang dieser Referenzspannung geht damit auch in die Schwingamplitude ein.

Weiterhin hat die Schwingamplitude gegen Masse beide Vorzeichen entsprechend einer Diodenflußspannung von maximal 0,7 V nach Plus und dann durch den Aufbau einer Resonanzschwingung am Schwingkreis L, C auch -0,7 V nach Minus.

Da bei integrierten Lösungen die Transistoren gewöhnlich in Isolationswannen in einer epitaktischen Schicht auf einem Substrat realisiert sind, kann dabei die durch die Kollektorwanne und das Substrat gebildete Diode in Fluß kommen, wenn zwischen Substrat (Masse oder Minusanschluß) und einer Kollektorwanne negative Spannungen von größer 0,6 bis 0,7 V anliegen. Es besteht dann die Gefahr von Verkopplungen zwischen Wannen, die an sich voneinander isoliert und entkoppelt sein sollen.

Weiterhin werden die negativen Halbwellen der Schwingungen durch die vorgenannte Substratdiode begrenzt, wodurch wiederum die Qualität des Oszillators begrenzt wird.

Der Erfindung liegt die Aufgabe zugrunde, eine Schaltungsanordnung der in Rede stehenden Art anzugeben, die temperaturstabiler ist und von Substratdioden-Effekten weitestgehend frei ist.

Diese Aufgabe wird bei einer Schaltungsanordnung der eingangs genannten Art erfindungsgemäß durch die Merkmale des kennzeichnenden Teils des Patentanspruchs 1 gelöst.

Ausgestaltungen des Erfindungsgedankens sind in Unteransprüchen gekennzeichnet.

Die Erfindung wird im folgenden anhand von in den Fig. 2 bis 7 der Zeichnungn dargestellten Ausführungsbeispielen näher erläutert. Es zeigt:
Fig. 2 ein Schaltbild einer Ausführungsform einer erfindungsgemäßen Oszillator/Demodulator-Schaltungsanordnung;
Fig. 3 bis 5 jeweils ein Teilschaltbild zur Erläuterung der Wirkungsweise der Schaltungsanordnung nach Fig. 2; und
Figs. 6 und 7 jeweils ein ebenfalls der Erläuterung der Wirkungsweise der Schaltungsanordnung nach Fig. 2 dienendes Strom-Spannungsdiagramm.

In der Schaltungsanordnung nach Fig. 2 entsprechen die Elemente T₁ bis T₃, R_{E} sowie L, C den bereits erläuterten Elementen der bekannten Schaltungsanordnung nach Fig. 1. Da die erfindungsgemäße Schaltungsanordnung vorzugsweise in integrierter Schaltungstechnik ausgeführt wird, ist ein Eingangsanschluß 10 herausgeführt dargestellt, an den der Parallelresonanzkreis L, C außen anschließbar ist. Entsprechendes gilt für herausgeführte Anschlüsse 11, 12 und 13. Am Anschluß 11 ist ein Widerstand R_{A} außen anschließbar, welcher in an sich bekannter Weise der Einstellung des Schaltabstands (Abstand des Metallblechs bzw. der Metallfahne M, bei dem der Annäherungsschalter schaltet) sowie der Schaltabstandshysterese für einen die erfindungsgemäße Oszillator/Demodulator-Schaltungsanordnung enthaltenden induktiven Annäherungsschalter dient. Dazu wird auf die eingangs genannte Druckschrift hingewiesen, in der die vorbekannte Schaltungsanordnung nach Fig. 1 beschrieben ist.

An den Anschluß 12 ist außen ein Integrationskondensator C₁ anschließbar, auf dessen Wirkungsweise hier auch nicht näher eingegangen wird, da seine Funktion an sich nicht erfindungswesentlich ist.

Am Anschluß 13 ist in die Schaltungsanordnung eine Versorgungsspannung Uᵥ einspeisbar.

Die Schaltungsanordnung gemäß Fig. 2 enthält weiterhin einen als Diode geschalteten, von einer Stromquelle l gespeisten Transistor T₁₀, der zum einen als Kompensationselement für die Schwellspannung der Basis-Emitterstrecke des die Verstärkerstufe des Oszillator/Demodulators bildenden Transistors T₁ wirkt. Insofern entspricht die Wirkungsweise dieses als Diode geschalteten Transistors T₁₀ der Wirkungsweise einer der Dioden in der vorbekannten Schaltungsanordnung nach Fig. 1. Wie im folgenden jedoch noch genauer erläutert wird, geht die Funktion dieses als Diode geschalteten Transistors T₁₀ über die Funktion der entsprechenden Diode in der vorbekannten Schaltungsanordnung nach Fig. 1 hinaus, so daß sich deren Wirkungsweisen nicht mehr voll decken.

In der erfindungsgemäßen Schaltungsanordnung nach Fig. 2 bildet der als Diode geschaltete Transistor T₁₀ mit zwei weiteren Transistoren T₁₁ und T₁₂, in deren Emitterzweig jeweils ein Widerstand R₁₁ bzw. R₁₂ nach Masse liegt, einen ersten Stromspiegel, wobei der als Diode geschaltete Transistor T₁₀ als Bezugselement für diesen ersten Stromspiegel und die beiden Transistoren T₁₁ und T₁₂ mit dem jeweiligen Emitterwiderstand R₁₁, R₁₂ von diesem Bezugselement an ihren Basen gemeinsam angesteuert werden. Dabei sind der als Bezugselement dienende, als Diode geschaltete Transistor T₁₀ und die Basen der Transistoren T₁₁ und T₁₂ des ersten Stromspiegels sowie die Basis des die Verstärkerstufe bildenden Transistors T₁ miteinander verbunden; diese Verbindung wird im folgenden auch als "Basisschiene" bezeichnet.

Die erfindungsgemäße Schaltungsanordnung nach Fig. 2 enthält weiterhin einen zweiten Stromspiegel, der durch einen als Diode geschalteten Transistor T₁₃ sowie einen Transistor T₁₄ mit einem an der Versorgungsspannung liegenden Widerstand R₁₄ im Emitterzweig gebildet wird. In diesem zweiten Stromspiegel bildet der als Diode geschaltete Transistor T₁₃ ein Bezugselement, das den Transistor T₁₄ steuert. In den beiden Stromspiegeln sind die Kollektor-Emitterstrecken der Transistoren T₁₁ und T₁₃ bzw. T₁₂ und T₁₄ in Reihe geschaltet. Die Transistoren T₁₀, T₁₁, T₁₂ des ersten Stromspiegels besitzen gegenüber den Transistoren T₁₃, T₁₄ des zweiten Stromspiegels entgegengesetzten Leitungstyp. Weiterhin sind die Widerstände R₁₁, R₁₂ in den Emitterzweigen der gesteuerten Transistoren T₁₁, T₁₂ des ersten Stromspiegels größer als der Widerstand R₁₄ im Emitterzweig des gesteuerten Transistors T₁₄ im zweiten Stromspiegel.

Der Verbindungspunkt der Kollektoren der Transistoren T₁₂ und T₁₄ liegt an einem Ausgang 14 der erfindungsgemäßen Oszillator/ Demodulator-Schaltungsanordung.

Ersichtlich bilden die beiden vorstehend erläuterten Stromspiegel einen im Eingangskreis der Transistorverstärkerstufe T₁ wirksamen Doppelstromspiegel, wobei sich die von ihnen gelieferten Ströme, d.h. die Kollektorströme der Transistoren T₁₂ und T₁₄, am Schaltungsausgang 14 subtrahieren.

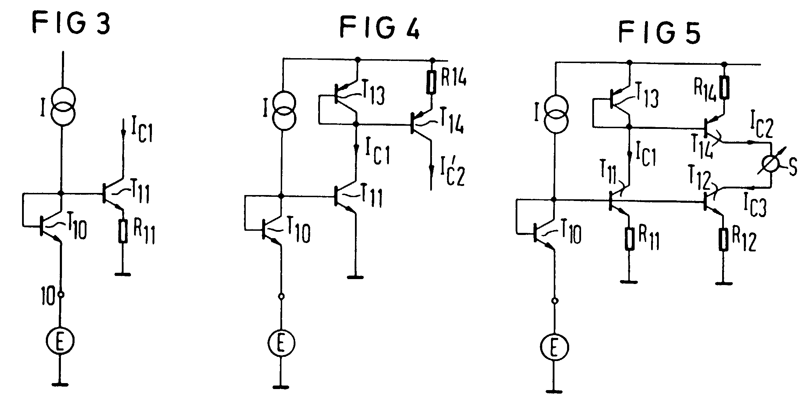

Um anzudeuten, daß die erfindungsgemäße Oszillator/Demodulator-Schaltungsanordnung einen Strom für nachfolgende Stufen in einem induktiven Annäherungsschalter liefern muß, ist in Fig. 2 weiterhin schematisch ein Schmitt-Trigger 20 dargestellt, in dem lediglich ein Eingangstransistor T₂₀ näher bezeichnet ist. Hierbei handelt es sich um eine an sich bekannte Stufe, die daher nicht näher erläutert wird. Wesentlich ist lediglich, daß die Oszillator/Demodulator-Schaltungsanordnung einen Ausgangsstrom zur Steuerung des Transistors T₂₀ im Schmitt-Trigger liefern muß, wie dies anhand der Fig. 3 bis 7 noch näher erläutert wird.

Um die Wirkungsweise der erfindungsgemäßen Schaltung erläutern zu können, wird gemäß Fig. 3 am Anschluß 10 anstelle des Resonanzkreises L, C gemäß Fig. 2 eine eine variable eingeprägte Spannung liefernde Quelle E angenommen. Zur weiteren Erklärung sei zunächst davon ausgegangen, daß der als Diode geschaltete Transistor T₁₀ immer von einem von der Stromquelle l gelieferten konstanten Strom von beispielsweise 10 µA durchflossen wird. Für Standardstrukturen mißt man dann an diesen als Diode geschalteten Transistor T₁₀ eine Flußspannung von 620 mV. Es wird weiter davon ausgegangen, daß der als Diode geschaltete Transistor T₁₀ sowie die Transistoren T₁₁, T₁₂ und T₁ gleiche Strukturen besitzen.

Ist die von der Quelle E gelieferte Spannung gleich Null, so führen die Transistoren T₁₁, T₁₂ und T₁ den gleichen Strom, solange die jeweiligen Emitterwiderstände R₁₁, R₁₂ und R_{E} unwirksam sind.

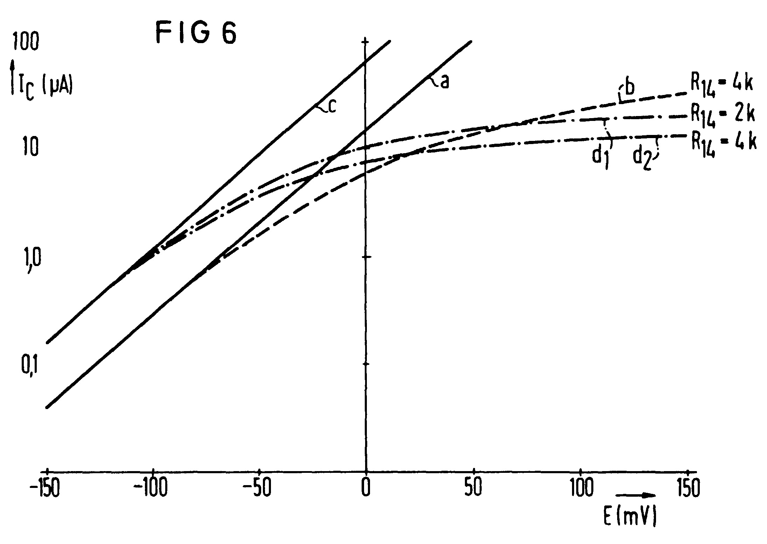

Variiert man die von der Quelle E gelieferte Spannung beispielsweise von -150 mV bis +150 mV, die dies im Diagramm nach Fig. 6 dargestellt ist, so ändern sich die Kollektorströme der genannten Transitoren gemäß der an sich bekannten Diodengleichung für die Basis-Emitterstrecke von Transistoren. Dieser Zusammenhang ist im Diagram nach Fig. 6, in dem auf der Ordinate der Kollektorstrom l_{c} logarithmisch aufgetragen ist, durch eine Gerade a aufgetragen.

Sind die Emitterwiderstände jedoch wirksam, so liegt der Verlauf der Kollektorströme gemäß einer Kurve b unterhalb der ursprünglichen Kurve a. Solange der Spannungsabfall an den Emitterwiderständen wesentlich kleiner als etwa 10 mV bleibt, ist die Abweichung von der Kurve a kaum merklich. Aufgrund des bereits genannten logarithmischen Diodengesetzes bedeutet eine Erhöhung der Basis-Emitter-Steuerspannung um 1 mV immer eine Erhöhung des Kollektorstroms um 4%. Je größer allerdings der Spannungsabfall an den Emitterwiderständen wird, um so stärker wird die Abweichung von der Kurve a.

Bei größeren Emitterflächen eines gesteuerten Transistors in einem Stromspiegel, beispielsweise um einen Faktor m, ist auch der Kollektorstrom um eben diesen Faktor m größer, solange ein Emitterwiderstand unwirksam ist. Dieser Fall ist durch eine Kurve c im Diagramm nach Fig. 6 dargestellt. Diese Kurve c verläuft exakt parallel zur Kurve a im Abstand m. Bei wirksamen Emitterwiderstand ergibt sich ebenso wie im Fall der Kurven a und b eine Abweichung von der Geraden, wie dies durch Kurven d1 und d2 dargestellt ist, wobei diese beiden Kurven für unterschiedliche Werte des Emitterwiderstands gelten. Bei einem Flächenverhältnis m von insbesondere 4 ist eine um etwa 36 mV kleinere Basis-Emitter-Steuerspannung für den gleichen Kollektorstrom verglichen mit der Bezugsstruktur erforderlich. Entsprechend der kleineren erforderlichen Basis-Emitter-Steuerspannung kann der Spannungsabfall am Emitterwiderstand für den gleichen Kollektorstrom größer sein. Infolgedessen biegen die Kurven d1 und d2 für unterschiedliche Werte des Emitterwiderstands härter von der Kurve c ab, als die Kurve b von der Kurve a.

Die in der Kurve a bzw. b dargestellten Verhältnisse entsprechen einem Stromspiegel nach Fig. 3 bzw. dem Stromspiegel T₁₀, T₁₁, T₁₂ und T₁ (im folgenden auch als "Strombank" bezeichnet).

Die durch die Kurven c bzw. d₁, d₂ dargestellten Verhältnisse entsprechen einem Stromspiegel nach Fig. 4 bzw. dem Stromspiegel T₁₃, T₁₄, R₁₄ angesteuert durch den Kollektorstrom des Transistors T₁₁, der in den Fig. 3 bis 5 mit l_{c1} bezeichnet ist.

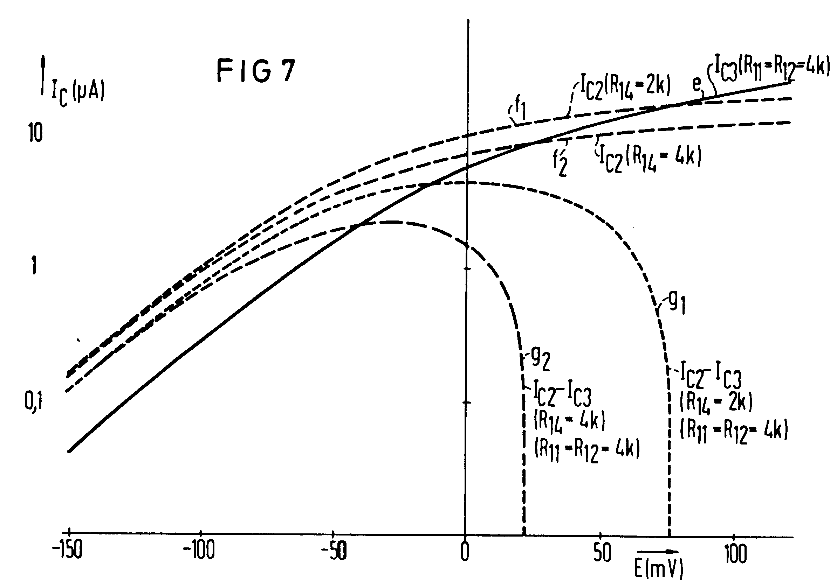

Der in den Ausgang 14 fließende Differenzstrom entspricht etwa der Differenz der Kurven b und dl, d2 nach Fig. 6. Dieser Sachverhalt ist in Fig. 5 derart dargestellt, daß die Verbindung der Kollektoren der Transistoren T₁₄ und T₁₂ als aufgetrennt gedacht ist und die Differenz des jeweiligen mit l_{c2} bzw. l_{c3} bezeichneten Kollektorstroms durch ein Meßinstrument S gemessen wird. Die Differenz l_{c2}-l_{c3} ist im Diagramm nach Fig. 7 für den jeweiligen Verlauf dl bzw. d2 nach Fig. 6 in Form von Kurven g1 bzw. g2 dargestellt. Die Ströme l_{c3} und l_{c2} sind im Diagramm nach Fig. 7 durch Kurven e sowie f1 und f2 dargestellt, wobei die Kurven f1 und f2 entsprechend den Kurven d1 und d2 nach Fig. 6 wiederum für verschiedene Werte der Emitterwiderstände gelten. Auch im Diagramm nach Fig. 7 ist der Strom auf der Ordinate logarithmisch aufgetragen.

Wie das Diagramm nach Fig. 7 zeigt, ist der Differenzstrom l_{c2}-l_{c3} gemäß den Kurven g1, g2 im gesamten Bereich in der Zeichenebene links von einem jeweiligen Schnittpunkt der Kurven f1, f2 und e positiv, d.h., der vom Kollektor des pnp-Transistors T₁₄ kommende Strom l_{c2} ist größer als der Kollektorstrom l_{c3} des npn-Transistors T₁₂. In diesem Bereich wird der Schmitt-Trigger 20 nach Fig. 2 aktiviert. Oberhalb bzw. rechts davon fällt der Differenzstrom steil ab und wechselt schließlich das Vorzeichen, so daß der Schmitt-Trigger 20 nach Fig. 2 deaktiviert wird.

Die Differenzstromkurve g1 bzw. g2 zeigt praktisch eine Gleichrichtercharakteristik. Steigt die von der Quelle E gemäß den Fig. 3 bis 5 gelieferte Steuerspannung über den durch den jeweiligen vorgenannten Schnittpunkt an, so kommt der npn-Transistor T₁₂ in Sättigung. Es gilt dann nicht mehr der Zusammenhang, daß der Basisstrom gleich dem Quotienten aus Kollektorstrom und Stromverstärkung ist. Der Basisstrom steigt erheblich an, so daß die Strombank unwirksam wird.

Während die Impedanz an der durch die miteinander verbundenen Basen der Transistoren T₁₁, T₁₂ und T₁ gebildeten Basisschiene vorher sehr hoch war (etwa gleich dem Produkt der Werte der Emitterwiderstände und der Stromverstärkung), wird sie für Steuerspannungen, die größer als die den vorgenannten Schnittpunkten nach Fig. 7 entsprechenden Spannungen sind, um den Faktor der Stromverstärkung kleiner.

Der Rückkopplungsweg der Oszillator/Dämpfungs-Schaltungsanordnung nach Fig. 2 wird über den die Oszillatorverstärkerstufe bildenden Transistor T₁ und den Stromspiegel T₂, T₃, R₃ geschlossen. Am Eingangsanschluß 10 liegt anstelle der zum Zwecke der Erläuterung angenommenen Stuersignalquelle E nach den Fig. 3 bis 5 der Parallelresonanzkreis L, C eines Annäherungsschalters, wie dies eingangs bereits erläutert wurde. Ein Ansteigen der Spannung an diesem Resonanzkreis bewirkt einen steigenden Strom durch den Transistor T₁. Dieser Strom wird über den Stromspiegel T₂, T₃, R₃ gespiegelt und auf den Resonanzkreis rückgeführt (R₃ hat dabei nur eine gewisse stabilisierende Wirkung). Dieser Strom steigt ebenfalls an. An der Impedanz des Resonanzkreises führt dies wiederum zu einem Anstieg der Spannung, wobei diese Wirkung der Auslösung gleichgerichtet ist, d.h., es handelt sich um eine Mitkopplung, wie sie zur Auslösung jeder Schwingung erforderlich ist.

Die Schaltungsanordnung nach Fig. 2 enthält mehrere Stromquellen bzw. Stromsenken im erläuterten Sinne, die gemeinsam von der Steuerspannung am Eingangsanschluß 10 gesteuert werden. Dabei besitzen die Transistoren T₁₃, T₁₄ des zweiten Stromspiegels unterschiedliche Emitter-Flächenverhältnisse, wobei die Emitter-Flächenverhältnisse des als Bezugselement wirkenden Transistors T₁₃ und des gesteuerten Transistors T₁₄ insbesondere gleich 1:4 sind. Die Transistoren T₁₀, T₁₁ und T₁₂ im ersten Stromspiegel besitzen gleiche oder von 1 nicht sehr verschiedene Emitter-Flächenverhältnisse. Insbesondere sind auch die Widerstände R₁₁, R₁₂ in den Emitterzweigen der gesteuerten Transistoren T₁₁, T₁₂ im ersten Stromspiegel größer als der Widerstand R₁₄ im Emitterzweig des gesteuerten Transistors T₁₄ im zweiten Stromspiegel.

Durch die durch die Transistoren T₁₀ und T₁₁ (mit gleichen Flächenverhältnissen) gebildete Stromsenke (Fig. 3) fließt für eine Steuerspannung Null (bei unwirksamen Emitterwiderstand R₁₁) ein Strom, der gleich dem in die Diode T₁₀ eingeprägten Strom ist. Der Verlauf des Ausgangsstroms l_{c1} (Fig. 3) als Funktion der Eingangs-Steuerspannung entprcicht der Kurve b im Diagramm nach Fig. 6.

Dieser Strom l_{c1} fließt gemäß Fig. 4 in die durch die pnp-Transistoren T₁₃, T₁₄ (mit unterschiedlichen Flächenverhältnissen) aufgebaute Stromquelle. Der von dieser Stromquelle gelieferte Strom l_{c2}' ist um den Faktor m größer als der Strom l_{c1}, wenn m der Faktor ist, um den die Emitterfläche des Transistors T₁₄ größer als diejenige des Transistors T₁₃ ist. Dies gilt solange, als am entsprechenden Emitterwiderstand R₁₄ nur ein vernachlässigbar kleiner Spannungsabfall auftritt. Der Strom l_{c2} dieser Stromquelle steigt aber für große Ströme aufgrund des dann größeren Spannungsabfalls im Verhältnis weniger stark an als der Strom l_{c3} in dem eine Stromsenke bildenden Transistor T₁₂ gemäß Fig. 5. Dieser Sachverhalt ist im Diagramm nach Fig. 7 für unterschiedliche Werte des Widerstands R₁₄ in der jeweiligen Kurve F1 bzw. f2 dargestellt, welche den Kurven d1, d2 nach Fig. 6 entsprechen.

Die nachfolgende Schaltung in Form des Schmitt-Triggers 20 nach Fig. 2 wird vom Ausgangsanschluß 14, d.h. vom Verbindungspunkt der Kollektoren der Transistoren T₁₄ und T₁₂ angesteuert, d.h., die Differenz dieser beiden Kollektorströme l_{c2} und l_{c3} steht zur Ansteuerung des Eingangstransistors T₂₀ des Schmitt-Triggers 20 zur Verfügung. Wie bereits anhand der Diagramme nach den Fig. 6 und 7 erläutert wurde, ist der Kollektorstrom l_{c2} der Stromquelle T₁₄ für kleine Ströme (also für negative Werte der Steuerspannung E) immer größer als der Strom l_{c3} der Stromsenke T₁₂. Die Stromdifferenz l_{c2}-l_{c3} ist also für negative Steuerspannungen E immer positive. Der Kollektorstrom des die Stromquelle bildenden Transistors T₁₄ steight jedoch bei größeren Strömen nur noch schwach an, so daß der Strom l_{c3} ab einem bestimmten Wert der Steuerspannung überwiegt und sich-theoretisch-eine negative Stromdifferenz ergibt. Der Spannungsanstieg am Resonanzkreis L, C wird dann begrenzt, wenn die oben bereits erläuterte Sättigung des als Stromsenke wirkenden Transistors T₁₂ eintritt, wobei dann die Impedanz an der Basisschiene der Transistoren T₁₁, T₁₂, T₁ abfällt, wodurch der Resonanzkreis L, C drastisch (um mehr als den Faktor 100) stärker belastet wird und die Verstärkung sinkt. Nachdem die Amplitude am Schwingkreis bei dieser Begrenzung ihr Maximum erreicht hat, fällt sie in der gleichen Weise wie sie vorher angestiegen ist. Die im Schwingkreis gespeicherte Energie bewirkt, daß die Amplitude in negativer Richtung genau so groß wie in positiver Richtung wird (eine Gleichstromkomponente, d.h. eine Unsymmetrie ist am Schwingkreis nicht möglich).

Die Höhe der Begrenzung ist durch die Steurspannung gegeben, bei der die Differenz der eingeprägten Ströme l_{c2}-l_{c3} das Vorzeichen ändert. Sie wird durch die Dimensionierung der Emitterwiderstände R₁₁, R₁₂, R₁₄ sowie die Wahl der Emitter-Flächenverhältnisse im oben beschriebenen Sinne bestimmt.

Aus den vorstehenden Ausführungen ist ersichtlich, daß der erfindungsgemäße Doppelstromspiegel aufgrund der begrenzenden Wirkung gemäß den Kurven g1, g2 nach Fig. 7 gleichzeitig als Demodulator wirkt.

Für die vorstehenden Erläuterungen ist darauf hinzuweisen, daß der Begriff "Stromspiegel" im herkömmlichen Sinn eine exakte Proportionalität der Ströme in allen Zweigen impliziert. Die ist bei den betriebenen Stromspiegeln für kleine Ströme ebenfalls erfüllt (Kurven a und c in Fig. 6). Durch die beabsichtigte Unsymmetrie in den Emitterkreisen werden bewußt Transfer-Funktionen erreicht, die nicht mehr linearen Verlauf zeigen (Kurven b und d in Fig. 6). Im Sinne der Erfindung umfaßt der Begriff "Stromspiegel" diesen Sachverhalt mit.

Mit der erfindungsgemäßen Ausbildung des Doppelstromspiegels in einer Oszillator/Demodulator-Schaltungsanordnung wird eine Reihe von Vorteilen erreicht. Die Begrenzung (siehe Fig. 7) ist temperaturstabil und liegt bei Werten unterhalb von ca. 200 mV Spitze-Spitze. Weiterhin ist die Schleifenverstärkung größer und weniger streuend.

Die Impedanzen am Abgleichanschluß 11 (Außenwiderstand R_{A} nach Fig. 2) können niedriger gewählt werden und streuen weniger als in der Schaltungsanordnung Fig. 1. Schließlich ist auch die gleichzeitig erreichte Demodulationsfunktion temperaturstabil, da keine weiteren Dioden-Temperaturkoeffizienten zu berücksichtigen sind. Die Demodulationskennlinie verläuft steil, was einer hohen Verstärkung entspricht.

## Patentansprüche

1. Oszillator/Demodulator-Schaltungsanordnung für einen induktiven Annäherungsschalter mit einer Transistorverstärkerstufe (T₁, R_{E}; T₁, R_{E}, R_{A}), in deren Eingangskreis ein bedämpfbarer Resonanzkreis (L, C) liegt, mit einer Mitkopplung (T₂, T₃, R₃) vom Ausgangskreis auf den Eingangskreis der Transistorverstärkerstufe (T₁, R_{E}; T₁, R_{E}, R_{A}), und mit einem Begrenzerzweig (T_{10,} T₁₂) im Eingangskreis der Transistorverstärkerstufe (T₁, R_{E}),
**dadurch gekennzeichnet,**
daß ein im Eingangskreis der Transistorverstärkerstufe (T₁, R_{E}) wirksamer Doppelstromspiegel (T₁₀, T₁₁, T₁₂, R₁₁, R₁₂; T₁₄, T₁₄, R₁₄) vorgesehen ist, in dem ein erster Stromspiegel T₁₀, T₁₁, T₁₂, R₁₁, R₁₂) und ein zweiter Stromspiegel (T₁₃, T₁₃, R₁₄) derart miteinander gekoppelt sind, daß sich die von ihnen gelieferten Ströme (I_{c2}, I_{c3}) an einem Schaltungsausgang (14) subtrahieren, daß der Steuerstrom des ersten Stromspiegels vom Stromfluß durch ein den Resonanzkreis (L, C) mit dem Steuereinang der Transistorverstärkerstufe (T₁, R_{E}, R_{A}) verbindendes Bezugselement (T₁₀) bestimmt wird und der zweite Stromspiegel vom ersten Stromspiegel angesteuert ist, daß das Emitter-Flächenverhältnis der Transistoren (T₁₃, T₁₄) des zweiten Stromspiegels (T₁₃, T₁₄, R₁₄) vom Emitter-Flächenverhältnis der Transistoren (T₁₀, T₁₁, T₁₂) des ersten Stromspiegels (T₁₀, T₁₁, T₁₂, R₁₁, R₁₂) verschieden ist,
daß die Emitterflächen-Verhältnisse der Transistoren (T₁₃, T₁₄; T₁₀, T₁₁, T₁₂) der Stromspiegel und Widerstände (R₁₄; R₁₁, R₁₂) in den Emitterzweigen der Transistoren der Stromspiegel derart eingestellt sind, das beide Stromspiegel unterschiedliche Verläufe ihrer Stromübersetzungsfaktoren aufweisen, so daß am Schaltungsausgang (14) eine Stromdifferenz entsteht, die von der Spannung am Resonanzkreis abhängig ist.

2. Schaltungsanordnung nach Anspruch 1, dadurch gekennzeichnet, daß die Ausgänge des ersten und zweiten Stromspiegels (T₁₀, T₁₁, T₁₂, R₁₁, R₁₂ bzw. T₁₃, T₁₄, R₁₄) zum Schaltungsausgang (14) zusammengeschaltet sind.

3. Schaltungsanordnung nach Anspruch 1 oder 2, dadurch gekennzeichnet, daß der erste Stromspiegel (T₁₀, T₁₁, T₁₂, R₁₁, R₁₂) folgende Komponenten aufweist:
einen als Diode geschalteten Transistor (T₁₀), der als Bezugselement für diesen Stromspiegel und als Kompensationselement für die Schwellspannung der Basis-Emitterstrecke der Transistorverstärkerstufe (T₁, R_{E}) wirkt, zwei von dem als Diode geschalteten Transistor (T₁₀) gemeinsam gesteuerte Transistoren (T₁₁, T₁₂) sowie jeweils einen im Emitterzweig der gesteuerten Transistoren (T₁₁, T₁₂) liegenden Widerstand (R₁₁, R₁₂).

4. Schaltungsanordnung nach Anspruch 3, dadurch gekennzeichnet, daß die Werte der Widerstände (R₁₁, R₁₂) in den Emitterzweigen der gesteuerten Transistoren (T₁₁, T₁₂) des ersten Stromspiegels (T₁₀, T₁₁, T₁₂, R₁₁, R₁₂) gleich sind.

5. Schaltungsanordnung nach einem der Ansprüche 1 bis 4, dadurch gekennzeichnet, daß der zweite Stromspiegel (T₁₃, T₁₄, R₁₄) einen als Diode geschalteten, als Bezugselementwirkenden Transistor (T₁₃), einen von diesem gesteuerten Transistor (T₁₄) sowie einen im Emitterzweig des gesteuerten Transistors (T₁₄) liegenden Widerstand (R₁₄) aufweist.

6. Schaltungsanordnung nach einem der Ansprüche 1 bis 5, dadurch gekennzeichnet, daß die Transistoren (T₁₀, T₁₁, T₁₂) des ersten Stromspiegels (T₁₀, T₁₁, T₁₂, R₁₁, R₁₂) entgegengesetzten Leitungstyp wie die Transistoren (T₁₃, T₁₄) des zweiten Stromspiegels (T₁₃, T₁₄, R₁₄) besitzen.

7. Schaltungsanordnung nach einem der Ansprüche 1 bis 6, dadurch gekennzeichnet, daß die Transistoren (T₁₀, T₁₁, T₁₂) des ersten Stromspiegels (T₁₀, T₁₁, T₁₂, R₁₁, R₁₂) gleiche oder von 1 nicht sehr verschiedene Emitter-Flächenverhältnisse besitzen.

8. Schaltungsanordnung nach einem der Ansprüche 1 bis 7, dadurch gekennzeichnet, daß die Emitterfläche des gesteuerten Transistors (T₁₄) des zweiten Stromspiegels (T₁₃, T₁₄, R₁₄) groß gegen die Emitterfläche des als Bezugselement wirkenden Transistors (T₁₃) ist.

9. Schaltungsanordnung nach Anspruch 8, dadurch gekennzeichnet, daß die Emitter-Flächenverhältnisse des als Bezugselement wirksamen Transistors (T₁₃) und des gesteuerten Transistors (T₁₄) im zweiten Stromspiegel (T₁₃, T₁₄, R₁₄) gleich 1:4 sind.

10. Schaltungsanordnung nach einem der Ansprüche 1 bis 9, dadurch gekennzeichnet, daß die Widerstände (R₁₁, R₁₂) in den Emitterzweigen der gesteuerten Transistoren (T₁₁, T₁₂) des ersten Stromspiegels (T₁₀, T₁₁, T₁₂, R₁₁, R₁₂) größer als der Widerstand (R₁₄) im Emitterzweig des gesteuerten Transistors (T₁₄) des zweiten Stromspiegels (T₁₃, T₁₄, R₁₄) sind.

## Claims

1. Oscillator/demodulator circuit arrangement for an inductive proximity switch with a transistor amplifier stage (T₁, R_{E}; T₁, R_{E}, R_{A}), in the input circuit of which there is a dampable resonant circuit (L, C), having regenerative feedback (T₂, T₃, R₃) from the output circuit to the input circuit of the transistor amplifier stage (T₁, R_{E}; T₁, R_{E}, R_{A}), and having a limiter branch (T₁₀, T₁₂) in the input circuit of the transistor amplifier stage (T₁, R_{E}), characterized in that a double current balancing circuit (T₁₀, T₁₁, T₁₂, R₁₁, R₁₂; T₁₃, T₁₄, R₁₄) effective in the input circuit of the transistor amplifier stage (T₁, R_{E}) is provided, in which double current balancing circuit a first current balancing circuit (T₁₀, T₁₁, T₁₂, R₁₁, R₁₂) and a second current balancing circuit (T₁₃, T₁₄, R₁₄) are coupled to one another in such a way that the currents (I_{c2}, I_{c3}) supplied by them are subtracted from one another at a circuit output (14), that the control current of the first current balancing circuit is determined by the current flow through a reference element (T₁₀) connecting the resonant circuit (L, C) to the control input of the transistor amplifier stage (T₁, R_{E}, R_{A}) and the second current balancing circuit is actuated by the first current balancing circuit, that the emitter area ratio of the transistors (T₁₃, T₁₄) of the second current balancing circuit (T₁₃, T₁₄, R₁₄) is different from the emitter area ratio of the transistors (T₁₀, T₁₁, T₁₂) of the first current balancing circuit (T₁₀, T₁₁, T₁₂, R₁₁, R₁₂), that the emitter area ratios of the transistors (T₁₃, T₁₄; T₁₀, T₁₁, T₁₂) of the current balancing circuits and resistors (R₁₄; R₁₁, R₁₂) in the emitter branches of the transistors of the current balancing circuits are set in such a way that both current balancing circuits have different variations in their current transformation factors so that a current difference arises at the circuit output (14), which difference is dependent on the voltage across the resonant circuit.

2. Circuit arrangement according to Claim 1, characterized in that the outputs of the first and of the second current balancing circuit (T₁₀, T₁₁, T₁₂, R₁₁, R₁₂ or T₁₃, T₁₄, R₁₄) are interconnected to form the circuit output (14).

3. Circuit arrangement according to Claim 1 or 2, characterized in that the first current balancing circuit (T₁₀, T₁₁, T₁₂, R₁₁, R₁₂) has the following components: a transistor (T₁₀) connected as a diode and acting as reference element for this current balancing circuit and as compensation element for the threshold voltage of the base-emitter path of the transistor amplifier stage (T₁, R_{E}), two transistors (T₁₁, T₁₂) commonly controlled by the transistor (T₁₀) connected as a diode and in each case a resistor (R₁₁, R₁₂) located in the emitter branch of the controlled transistors (T₁₁, T₁₂).

4. Circuit arrangement according to Claim 3, characterized in that the values of the resistors (R₁₁, R₁₂) in the emitter branches of the controlled transistors (T₁₁, T₁₂) of the first current balancing circuit (T₁₀, T₁₁, T₁₂, R₁₁, R₁₂) are the same.

5. Circuit arrangement according to one of Claims 1 to 4, characterized in that the second current balancing circuit (T₁₃, T₁₄, R₁₄) has a transistor (T₁₃) connected as a diode and acting as a reference element, a transistor (T₁₄) controlled by the latter and a resistor (R₁₄) located in the emitter branch of the controlled transistor (T₁₄).

6. Circuit arrangement according to one of Claims 1 to 5, characterized in that the transistors (T₁₀, T₁₁, T₁₂) of the first current balancing circuit (T₁₀, T₁₁, T₁₂, R₁₁, R₁₂) are of the opposite conduction type to that of the transistors (T₁₃, T₁₄) of the second current balancing circuit (T₁₃, T₁₄, R₁₄).

7. Circuit arrangement according to one of Claims 1 to 6, characterized in that the transistors (T₁₀, T₁₁, T₁₂) of the first current balancing circuit (T₁₀, T₁₁, T₁₂, R₁₁, R₁₂) have emitter area ratios which are the same or not very different from 1.

8. Circuit arrangement according to one of Claims 1 to 7, characterized in that the emitter area of the controlled transistor (T₁₄) of the second current balancing circuit (T₁₃, T₁₄, R₁₄) is large compared to the emitter area of the transistor (T₁₃) acting as reference element.

9. Circuit arrangement according to Claim 8, characterized in that the emitter area ratios of the transistor (T₁₃) acting as reference element and of the controlled transistor (T₁₄) in the second current balancing circuit (T₁₃, T₁₄, R₁₄) are equal to 1:4.

10. Circuit arrangement according to one of Claims 1 to 9, characterized in that the resistors (R₁₁, R₁₂) in the emitter branches of the controlled transistors (T₁₁, T₁₂) of the first current balancing circuit (T₁₀, T₁₁, T₁₂, R₁₁, R₁₂) are larger than the resistor (R₁₄) in the emitter branch of the controlled transistor (T₁₄) of the second current balancing circuit (T₁₃, T₁₄, R₁₄).

## Revendications

1. Circuit oscillateur/démodulateur pour un détecteur inductif de proximité comportant un étage amplificateur à transistor (T₁,R_{E}; T₁,R_{E},R_{A}), dont le circuit d'entrée contient un circuit résonnant (L,C) pouvant être amorti, et une boucle de réaction (T₂,T₃,R₃) reliant le circuit de sortie au circuit d'entrée de l'étage amplificateur à transistor (T₁, R_{E};T₁,R_{E},R_{A}) et une branche contenant un limiteur (T₁₀,T₁₂) insérée dans le circuit d'entrée de l'étage amplificateur à transistor (T₁,R_{E}), caractérisé en ce qu'il est prévu un miroir de courant double (T₁₀,T₁₁,T₁₂,R₁₁,R₁₂; T₁₃, T₁₄, R₁₄), qui agit dans le circuit d'entrée de l'étage amplificateur à transistor (T₁, R_{E}) dans lequel un premier miroir de courant (T₁₀,T₁₁,T₁₂, R₁₁,R₁₂) et un second miroir de courant (T₁₃,T₁₄,R₁₄) sont accouplés entre eux de manière que les courants (I_{c2},I_{c3}), qu'ils délivrent, sont soustraits l'un de l'autre au niveau d'une sortie (14) du circuit, en ce que le courant de commande du premier miroir de courant est déterminé par le flux de courant traversant un élément de référence (T₁₀), qui relie le circuit résonnant (L,C) à l'entrée de commande de l'étage amplificateur à transistor (T₁,R_{E},R_{A}), et le second miroir de courant est commandé par le premier miroir de courant, en ce que le rapport de surface d'émetteur des transistors (T₁₃,T₁₄) du second miroir de courant (T₁₃,T₁₄,R₁₄) est différent du rapport de surface d'émetteur des transistors (T₁₀,T₁₁,T₁₂) du premier miroir de courant (T₁₀,T₁₁,T₁₂,R₁₁,R₁₂), en ce que les rapports de surface d'émetteur des miroirs de courant et des résistances (R₁₄, R₁₁, R₁₂) sont fixés dans la branche émettrice des transistors des miroirs de courant de sorte que les deux miroirs de courant ont des variations différentes de leur facteur de conversion du courant de sorte qu'à la sortie (14) du circuit apparaît une différence de courant qui dépend de la tension appliquée au circuit résonnant.

2. Circuit suivant la revendication 1, caractérisé par le fait que la sortie des premier et second miroirs de courant (T₁₀,T₁₁,T₁₂,R₁₁,R₁₂ et T₁₃,T₁₄,T₁₄) sont interconnectés pour former la sortie (14) du circuit.

3. Montage suivant la revendication 1 ou 2, caractérisé par le fait que le premier miroir de courant (T₁₀, T₁₁, T₁₂, R₁₁, R₁₂) contient les composants suivants:
un transistor (T₁₀), branché en diode et agissant en tant qu'élément de référence pour ce miroir de courant et en tant qu'élément de compensation pour la tension de seuil de la voie base-émetteur de l'étage amplificateur à transistor (T₁,R_{E}),
deux transistors (T₁₁,T₁₂) commandés en commun par le transistor (T₁₀) branché en diode,
ainsi qu'une résistance respective (R₁₁,R₁₂) située dans la branche d'émetteur des transistors commandés (T₁₁,T₁₂).

4. Montage suivant la revendication 3, caractérisé par le fait que les valeurs des résistances (R₁₁,R₁₂) situées dans les branches d'émetteur des transistors commandés (T₁₁,T₁₂) du premier miroir de courant (T₁₀,T₁₁,T₁₂,R₁₁,R₁₂) sont égales.

5. Montage suivant l'une des revendications 1 à 4, caractérisé par le fait que le second miroir de courant (T₁₃,T₁₄,R₁₄) comporte un transistor (T₁₃) branché en diode et agissant en tant qu'élément de référence, un transistor (T₁₄) commandé par ce transistor et une résistance (R₁₄) située dans la branche d'émetteur du transistor commandé (T₁₄).

6. Circuit suivant l'une des revendications 1 à 5, caractérisé par le fait que les transistors (T₁₀,T₁₁,T₁₂) du premier miroir de courant (T₁₀,T₁₁,T₁₂,R₁₁,R₁₂) possèdent un type de conductivité opposé à celui des transistors (T₁₃,T₁₄) du second miroir de courant (T₁₃,T₁₄,R₁₄).

7. Circuit suivant l'une des revendications 1 à 6, caractérisé par le fait que les rapports des surfaces d'émetteurs des transistors (T₁₀,T₁₁,T₁₂) du premier miroir de courant (T₁₀,T₁₁,T₁₂,R₁₁,R₁₂) sont égaux ou très peu différents de 1.

8. Circuit suivant l'une des revendications 1 à 7, caractérisé par le fait que la surface d'émetteur du transistor commandé (T₁₄) du second miroir de courant (T₁₃,T₁₄,R₁₄) est grande par rapport à la surface d'émetteur du transistor (T₁₃) agissant en tant qu'élément de référence.

9. Montage suivant la revendication 8, caractérisé par le fait que les rapports entre les surfaces des émetteurs du transistor (T₁₃) agissant en tant qu'élément de référence et du transistor commandé (T₁₄) dans le second miroir de courant (T₁₃, T₁₄,R₁₄) sont égaux à 1:4.

10. Circuit suivant l'une des revendications 1 à 9, caractérisé par le fait que les résistances (R₁₁,R₁₂) situées dans les branches d'émetteur des transistors commandés (T₁₁,T₁₂) du premier miroir de courant (T₁₀,T₁₁,T₁₂,R₁₁,R₁₂) sont supérieures à la résistance (R₁₄) dans la branche d'émetteur du transistor commandé (T₁₄) du second miroir de courant (T₁₃,T₁₄,R₁₄).
